Europäisches Patentamt

European Patent Office

Office européen des brevets

(19)

(11) EP 0 774 672 A1

(12) EUROPÄISCHE PATENTANMELDUNG

(43) Veröffentlichungstag:
21.05.1997 Patentblatt 1997/21

(51) Int. Cl.⁶: G01R 33/48

(21) Anmeldenummer: 96203143.1

(22) Anmeldetag: 11.11.1996

(84) Benannte Vertragsstaaten:
DE FR GB NL

(30) Priorität: 18.11.1995 DE 19543079

(71) Anmelder:
• Philips Patentverwaltung GmbH
22335 Hamburg (DE)
Benannte Vertragsstaaten:
DE
• PHILIPS ELECTRONICS N.V.
5621 BA Eindhoven (NL)
Benannte Vertragsstaaten:
FR GB NL

(72) Erfinder:
• Börnert, Peter, Dr.,
c/o Philips
22335 Hamburg (DE)
• Schäffter, Tobias.,
c/o Philips
22335 Hamburg (DE)

(74) Vertreter: Hartmann, Heinrich, Dipl.-Ing. et al
Philips Patentverwaltung GmbH,
Röntgenstrasse 24
22335 Hamburg (DE)

(54) **Verfahren zum Bestimmen der räumlichen und/oder spektralen Verteilung der Kernmagnetisierung**

(57) Die Erfindung betrifft ein Verfahren zur Bestimmung der Kernmagnetisierungsverteilung in getrennten (räumlich oder frequenzmäßig nicht zusammenhängenden) Bereichen. Bei der Erfindung werden diese Bereiche - und nur diese - gemeinsam durch mehrdimensionale Hochfrequenzimpulse angeregt, wobei aus einer Linearkombination der im Anschluß an eine Anregung auftretenden MR-Signale (oder daraus abgeleitete MR-Daten) die Kernmagnetisierungsverteilung in den einzelnen Bereichen ermittelt werden kann. Die Erfindung ergibt kürzere Meßzeiten oder ein günstigeres Signal-Rausch-Verhältnis.

FIG. 4

**Beschreibung**

Die Erfindung betrifft ein Verfahren zum Bestimmen der räumlichen und/oder spektralen Verteilung der Kernmagnetisierung in getrennten Bereichen innerhalb eines Objektes. Bei MR-Untersuchungen (MR= Magnetresonanz) ist es oft erwünscht, räumlich nicht zusammenhängende (getrennte) Bereiche eines Objektes zu untersuchen:

a) So ist es z.B. bei der in-vivo-Spektroskopie wichtig, zwecks Bewertung der spektralen Kernmagnetisierungsverteilung in einem diagnostisch relevanten Bereich Vergleichsspektren auch aus nicht pathologischen Regionen heranzuziehen.

b) Bei den bildgebenden MR-Verfahren sind oft nur bestimmte Bereiche des Gesamtbildes von diagnostischen Interesse, so daß es nicht notwendig ist, den gesamten Untersuchungsbereich abzubilden. Die Möglichkeit, nur bestimmte Bereiche abzubilden, kann dann von Vorteil sein, wenn innerhalb eines Untersuchungsbereiches stark durchblutete Bereiche enthalten sind, die nicht von diagnostischen Interesse sind und die Ursache von starken Flußartefakten sein können. Es ist dann erwünscht, nur die anderen Bereiche anzuregen und abzubilden.

c) Weiterhin ist es oft von Interesse, getrennte Fett- bzw. Wasserbilder in verschiedenen Bereichen zu erzeugen, z.B. in zwei verschiedenen Ebenen. Die Fett- bzw. Wasserbilder werden dabei aus unterschiedlichen Frequenzbereichen der MR-Signale erzeugt. In diesem Fall gibt es also insgesamt vier getrennte Bereiche (zwei räumlich und zwei frequenzmäßig getrennte Bereiche), in denen die Kernmagnetisierungsverteilung ermittelt werden muß.

Es ist bereits bekannt, daß man mit Hilfe sogenannter mehrdimensionaler Hochfrequenzimpulse die Kernmagnetisierung in beliebig geformten, räumlich mehrdimensionalen Bereichen anregen oder refokussieren kann. Mehrdimensionale Hochfrequenzimpulse sind amplituden- und/oder phasenmodulierte Impulse, die in Anwesenheit von zeitlich variierenden magnetischen Gradientenfeldern longitudinale Magnetisierung anregen oder transversale Magnetisierung refokussieren. Derartige mehrdimensionale Hochfrequenzimpulse sind in J. Magn. Reson. 82, 647-654 (1989) beschrieben. Darüberhinaus ist in der Zeitschrift Magn. Reson. Med. 15, 287-304 (1990) die Erzeugung von gleichzeitig räumlich und spektral selektiven Hochfrequenzimpulsen beschrieben, mit denen jeweils einer von mehreren räumlich und frequenzmäßig getrennten Bereichen angeregt werden könnte. Auch diese Impulse sind als mehrdimensionale Hochfrequenzimpulse aufzufassen.

Aufgabe der vorliegenden Erfindung ist es, ein verbessertes Verfahren der eingangs genannten Art anzugeben. Bezeichnet man die Zahl der getrennten Bereiche mit n, dann steht die erfindungsgemäße Lösung dieser Aufgabe in den folgenden Schritten:

a) Vorgabe von n linear unabhängigen Kodierungen der Phase und/oder der Amplitude der Kernmagnetisierung in den n getrennten Bereichen.
b) Erzeugen von n verschiedenen mehrdimensionalen Hochfrequenzimpulsen, die so gestaltet sind, daß die Kernmagnetisierung nur in den n Bereichen angeregt wird, und zwar jeweils entsprechend einer der n Kodierungen.
c) Erfassung der MR-Signale, die im Anschluß an die Anregung der Kernmagnetisierung in den Bereichen auftreten.
d) Bildung von Linearkombinationen der MR-Signale oder daraus linear abgeleiteter MR-Daten zur Ermittlung der Kernmagnetisierungsverteilung in jeweils einem der Bereiche.

Bei der Erfindung werden also die zu untersuchenden, beliebig geformten Bereiche nicht einzeln (nacheinander) angeregt, sondern gleichzeitig. Das führt dazu, daß das aus einer solchen Anregung resultierende MR-Signal sich aus Signalkomponenten aus den verschiedenen Bereichen zusammensetzt, die den einzelnen Bereichen nicht mehr ohne weiteres zugeordnet werden könnten. Um dennoch die Kernmagnetisierungsverteilung in den einzelnen Bereichen rekonstruieren zu können, werden n verschiedene Hochfrequenzimpulse erzeugt, d.h. so viele verschiedene Hochfrequenzimpulse, wie getrennte Bereiche vorhanden sind. Diese sind so gestaltet, daß sie die Kernmagnetisierung in den Bereichen mit unterschiedlicher Kodierung anregen können, so daß man die Kernmagnetisierungsverteilung in den einzelnen Bereichen durch Bildung einer Linearkombination der von den verschiedenen Hochfrequenzimpulsen herrührenden MR-Signale bestimmen kann. Damit diese Bestimmung eindeutig ist, müssen die Kodierungen der n Hochfrequenzimpulse linear unabhängig sein (d.h. keine der Kodierungen darf sich aus einer Linearkombination der anderen Kodierungen ergeben).

Der Vorteil der Erfindung besteht darin, daß sich - bei gleicher Meßzeit - ein besseres Signal/Rausch-Verhältnis ergibt, als wenn man die Kernmagnetisierung in den einzelnen Bereichen nacheinander messen würde. Außerdem ist es von Vorteil. daß die Messungen in den einzelnen Bereichen gleichzeitig erfolgen, so daß die ermittelten Verteilungen besser in Relation zueinander stehen, als wenn sie nacheinander gemessen worden wären. Gegenüber zwei oder dreidimensionalen Abbildungsverfahren, die das gesamte Objekt inklusive der nicht interessierenden Areale abbilden, besteht der Vorteil darin, daß die Meßzeit verringert werden kann und daß die Artefaktanfälligkeit verringert ist, weil artefaktanfällige Strukturen durch die Hochfrequenzimpulse gar nicht beeinflußt werden, so daß sie auch nicht Ursache von Artefakten werden können.

Eine Weiterbildung zur Untersuchung räumlich getrennter Bereiche sieht vor, daß räumlich mehrdimensionale Hochfrequenzimpulse verwendet werden und daß die Schritte c) und ggf. b) mehrfach wiederholt werden, wobei nach jedem Hochfrequenzimpuls und vor der Erfassung des resultierenden MR-Signals ein erstes magnetisches Gradientenfeld mit in einer ersten Richtung verlaufendem Phasenkodiergradienten erzeugt wird, dessen zeitliches Integral vor jeder erneuten Erfassung eines MR-Signals verändert wird. Durch das von Wiederholung zu Wiederholung geänderte magnetische Gradientenfeld ergibt sich eine räumliche Auflösung in Richtung des Gradienten. Wenn in weiterer Ausgestaltung der Erfindung vorgesehen ist, daß während der Erfassung der MR-Signale jeweils ein magnetisches Gradientenfeld wirksam ist, dessen Gradient in einer dritten, zu der Richtung des bzw. der Phasenkodiergradienten senkrechten Richtung verläuft, kann die räumliche Verteilung der Kernmagnetisierung in den n getrennten Bereichen bestimmt werden. Der Vorteil gegenüber den konventionellen Verfahren zur zweidimensionalen Bestimmung der Kernmagnetisierungsverteilung besteht darin, daß in der Regel bei gleichem Auflösungsvermögen die Zahl der Wiederholungen niedriger sein kann, so daß sich eine verringerte Meßzeit ergibt.

Entsprechendes gilt, wenn in Ausgestaltung des Verfahrens vorgesehen ist, daß die Schritte c) und ggf. b) in mehreren Zyklen wiederholt werden wobei von Zyklus zu Zyklus das zeitliche Integral über das erste Gradientenfeld geändert wird, daß jeder Zyklus seinerseits mehrere Wiederholungen umfaßt, wobei vor einer erneuten Erfassung des resultierenden MR-Signals ein zweites magnetisches Gradientenfeld mit in einer zweiten Richtung verlaufendem Phasenkodierung erzeugt wird, dessen zeitliches Integral von Wiederholung zu Wiederholung verändert wird. In Verbindung mit einem Lesegradienten in einer zu den Phasenkodiergradienten senkrechten Richtung ist dabei eine dreidimensionale Bestimmung in den räumlich getrennten Bereichen möglich, wobei die Meßzeit in der Regel kürzer sein kann als bei konventionellen Verfahren zur dreidimensionalen Bestimmung der Kernmagnetisierungsverteilung.

In weiterer Ausgestaltung der Erfindung ist vorgesehen, daß räumlich mehrdimensionale Hochfrequenzimpulse verwendet werden und daß zwecks Bestimmung der spektralen Kernmagnetisierungsverteilung in den Bereichen während der Erfassung der MR-Signale keine magnetischen Gradientenfelder wirksam sind. Hierdurch wird eine getrennte Bestimmung der spektralen Kernmagnetisierungsverteilung in den einzelnen räumlichen Bereichen möglich, wobei das Signal/Rausch-Verhältnis günstiger ist als wenn man die einzelnen Bereiche durch entsprechende Hochfrequenzimpulse einzeln und nacheinander anregen würde.

In noch weiterer Ausgestaltung der Erfindung ist vorgesehen, daß mehrere räumlich getrennte Bereiche in mehreren getrennten Frequenzbereichen angeregt werden und daß die Zahl der Kodierungen bzw. der verschiedenen Hochfrequenzimpulse dem Produkt aus der Zahl der räumlich getrennten Bereiche und der Zahl der Frequenzbereiche entspricht. Hiermit ist beispielsweise die Bestimmung von Fett- und Wasserbildern in zwei getrennten Arealen gleichzeitig möglich.

Ein MR-Gerät zur Durchführung des erfindungsgemäßen Verfahren ist versehen mit

a) einer Hochfrequenzspulenanordnung zum Erzeugen von Hochfrequenzimpulsen
b) einer Gradientenspulenanordnung zum Erzeugen zeitlich veränderlicher magnetischer Gradientenfelder
c) einer Spulenanordnung zum Empfang von MR-Signalen
d) einer Rekonstruktionseinheit zum Rekonstruieren der Kernmagnetisierungsverteilung aus den empfangenen MR-Signalen
e) Mitteln zur Vorgabe der Phase und oder der Kodierung in n getrennten Bereichen
f) einer Steuereinheit zum Steuern der Komponenten derart, daß folgende Schritte durchgeführt werden:
g) Erzeugen von n verschiedenen Hochfrequenzimpulsen, die so gestaltet sind, daß die Kernmagnetisierung nur in den n Bereichen angeregt wird und zwar jeweils entsprechend einer der n Kodierungen.
h) Erfassung der MR-Signale, die im Anschluß an die Anregung der Kernmagnetisierung in den Bereichen auftreten.
i) Bildung von Linearkombinationen der MR-Signale oder daraus linear abgeleiteter MR-Daten zur Ermittlung der Kernmagnetisierungsverteilung in jeweils einem der Bereiche.

Die Erfindung wird nachstehend anhand der Zeichnungen näher erläutert. Es zeigen:

Fig. 1    das Blockschaltbild eines MR-Gerätes, mit dem die Erfindung ausführbar ist,

Fig. 2    ein MR-Übersichtsbild,

Fig. 3    einige ausgewählte Bereiche des Übersichtsbildes,

Fig. 4    den zeitlichen Verlauf verschiedener Signale bei einer Sequenz zur spektroskopischen Auswertung dieser Bereiche,

Fig. 5    eine zweidimensionale Abbildung eines Objektes mit ausgewählten Bereichen,

Fig. 6    eine dreidimensionale Darstellung eines Objektes mit ausgewählten Bereichen,

Fig. 7    den zeitlichen Verlauf der Signale bei einer für die Abbildung der Bereiche in den Figuren 5 und 6 geeigneten Sequenz,

Fig. 8    die Lage von räumlich und frequenzmäßig getrennten Bereichen,

Fig. 9 eine zur Abbildung dieser Bereiche geeignete Sequenz.

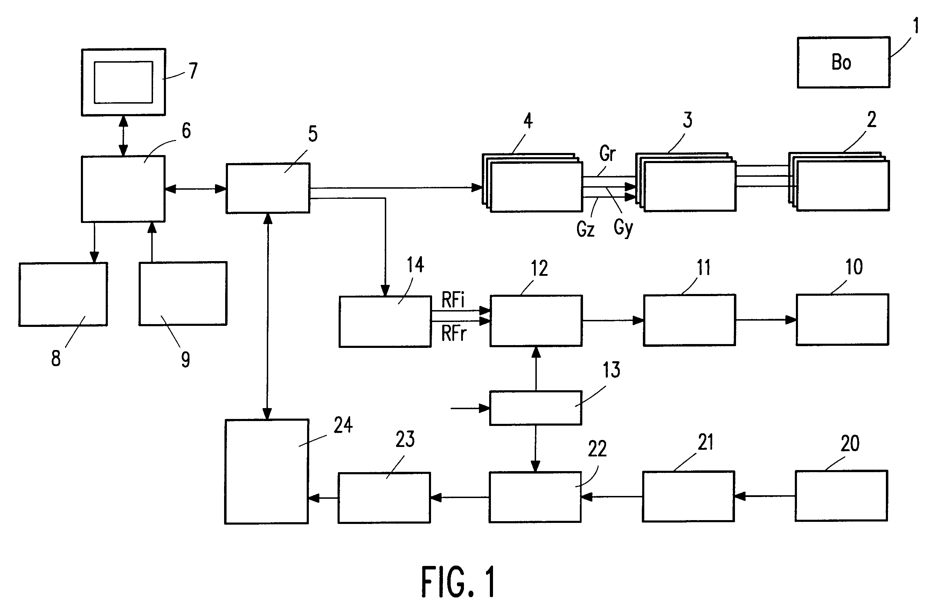

In Fig. 1 ist mit 1 ein schematisch dargestellter Hauptfeldmagnet bezeichnet, der in einem nicht näher dargestellten Untersuchungsbereich ein in z-Richtung verlaufendes, stationäres und homogenes Magnetfeld mit einer Stärke von z.B. 1,5 Tesla erzeugt. Weiterhin ist eine Gradienten-Spulenanordnung 2 vorgesehen, die in dem Untersuchungsbereich in z-Richtung verlaufende magnetische Gradientenfelder mit einem Gradienten in x-, y- oder z-Richtung erzeugen kann. Die Gradienten-Spulenanordnung 2 wird von einer Gradienten-Verstärkeranordnung 3 gespeist. Der zeitliche Verlauf der magnetischen Gradientenfelder wird von einer Generatoranordnung 4 vorgegeben, die von einer Steuereinheit 5 gesteuert wird. Die Steuereinheit 5 wirkt mit einer Workstation 6 zusammen. Die Workstation 6 ist mit einem Monitor 7 zur Wiedergabe von MR-Bildern versehen. Eingaben sind über eine Tastatur 8 oder eine interaktive Eingabeeinheit 9, z.B. ein Lichtgriffel, möglich.

Die Kernmagnetisierung im Untersuchungsbereich kann durch Hochfrequenzimpulse einer Hochfrequenzspule 10 angeregt werden, die an einen Hochfrequenzverstärker 11 angeschlossen ist, der die Ausgangssignale eines Hochfrequenzsenders 12 verstärkt. Im Hochfrequenzsender werden die komplexen Einhüllenden $RF_i$ und $RF_r$ des Hochfrequenzimpulses mit zwei um 90° versetzten Trägerschwingungen moduliert, die von einem Oszillator 13 geliefert werden, dessen Frequenz der Larmorfrequenz (bei einem Hauptfeld von 1.5 Tesla ca. 63 MHz) entspricht. Die komplexen Einhüllenden $RF_i$ und $RF_r$ werden von der Steuereinheit 5 in einen Generator 14 geladen, der mit dem Sender 12 gekoppelt ist.

Die im Untersuchungsbereich erzeugten MR-Signale werden von einer Empfangsspule 20 aufgenommen und von einem Verstärker 21 verstärkt. Das verstärkte Signal wird in einem Quadraturdemodulator 22 demoduliert und über einen Analog-Digital-Wandler 23 einer Rekonstruktionseinheit 24 zugeführt, die aus den digitalisierten MR-Signalen ein Bild der MR-Verteilung rekonstruiert. Dieses Bild kann auf dem Monitor 7 wiedergegeben werden.

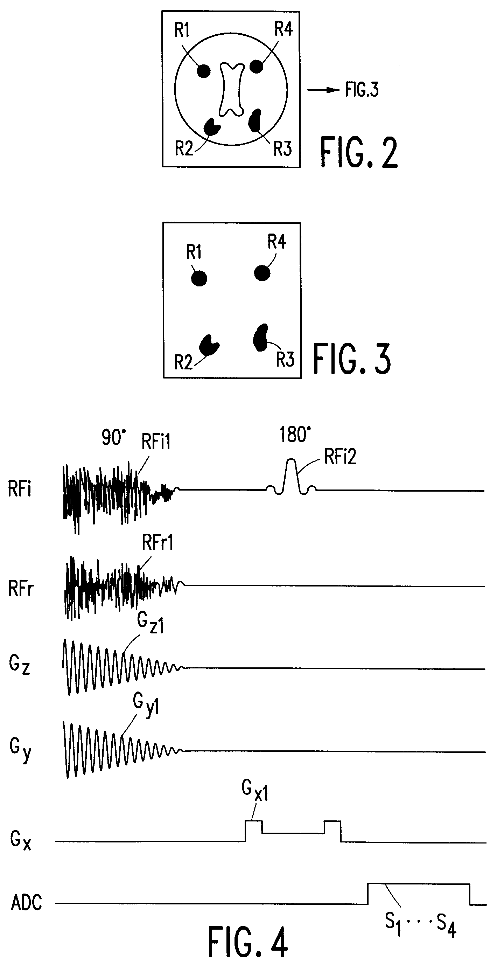

In der MR-Spektroskopie ist es vorteilhaft, anhand eines MR-Bildes die Bereiche festzulegen, aus denen ein MR-Spektrum ermittelt werden soll. Da die absolute Bewertung solcher Spektren oft durch die großen Unterschiede zwischen verschiedenen Patienten fragwürdig ist, ist es notwendig, Referenzwerte aus nicht pathologischen Bereichen heranzuziehen. Zu diesem Zweck werden in einem auf konventionelle Weise erstellten Schichtbild (Fig. 2), das auf dem Monitor 7 wiedergegeben wird, mittels der interaktiven Eingabeeinheit 9 vier getrennte, d.h. räumlich nicht zusammenhängende Bereiche R1...R4 vorgegeben, deren MR-Spektrum ermittelt werden soll. Grundsätzlich können die zu untersuchenden Bereiche aber auch automatisch mit Hilfe geeigneter Bildverarbeitungsverfahren vorgegeben werden.

Für diese vier Bereiche, die in Fig. 3 getrennt von dem übrigen MR-Bild dargestellt sind, werden vier linear unabhängige Kodierungen der Phase der transversalen Magnetisierung vorgegeben. Die Kodierung kann z.B. für die verschiedenen Bereiche z.B. wie folgt vorgegeben werden:

| Puls | R1 | R2 | R3 | R4 | MR-Signal |
|------|-----|-----|-----|-----|-----------|
| 1 | + | + | + | + | $\rightarrow$ S1 |
| 2 | + | + | - | - | $\rightarrow$ S2 |
| 3 | + | - | - | + | $\rightarrow$ S3 |
| 4 | + | - | + | - | $\rightarrow$ S4 |

Darin bedeutet "+", daß in dem betreffenden Bereich die Transversalmagnetisierung in einem mitrotierenden Koordinatensystem die Phasenlage Null hat, während "-" bedeuten soll, daß die Transversalmagnetisierung in dem betreffenden Bereich eine Phasenlage von 180° haben soll.

Dieses Kodierschema entspricht einer Vierpunkt-Hadamard-Transformation. Die Vorgabe der Kodierung könnte grundsätzlich interaktiv durch den Benutzer erfolgen, doch kann sie auch automatisch durch die Workstation 6 vorgegeben werden, sobald die Zahl der Bereiche festliegt. Anstelle der Kodierung der Kernmagnetisierung in den Bereichen entsprechend einer Hadamard-Transformation können auch beliebige andere Kodierungen verwendet werden, soweit sie linear unabhängig sind. Hierzu zählen auch die Wavelet- oder die Fouriertransformation. Diese und weitere Transformationen sind u.a. in Magn. Reson. Med. 24, 265-287 (1992) sowie in J.Opt. Soc. Amer., A4, 923-932, 1989, beschrieben.

Nach der Vorgabe der Kodierung können die komplexen Einhüllenden von vier zweidimensionale Hochfrequenzimpulse als Anregungsimpulse derart berechnet werden, daß die Vorzeichen der durch sie erzeugten Transversalmagnetisierung in den einzelnen Bereichen der vorgegebenen Kodierung entspricht. Ein räumlich zweidimensionaler Hochfrequenzimpuls ist ein Impuls, der von zeitlich veränderlichen magnetischen Gradientenfeldern mit in zwei zueinander senkrechten Richtungen verlaufenden Gradienten begleitet wird. Die Berechnung der Einhüllenden derartiger Hochfrequenzimpulse ist in der Zeitschrift J. Magn. Reson. 82, 647-654 (1989) beschrieben.

In Fig. 4 sind in den beiden ersten Zeilen die zeitlichen Verläufe der komplexen Einhüllenden $RF_{i1}$ und $FR_{r1}$ eines dieser vier Hochfrequenzimpulse dargestellt, die von cosinus- bzw. sinusförmigen Gradientenfeldern mit linear abnehmender Amplitude und in z- bzw. y-Richtung verlaufenden Gradienten $G_{z1}$ und $G_{y1}$ begleitet werden. Ein solcher zweidimensionaler Hochfrequenzimpuls regt die Kernmagnetisierung in den vier Bereichen R1...R4 an, und zwar nur in diesen Bereichen, wobei die Phasenlage der Transversalmagnetisierung in den einzelnen Bereichen einer der vorgegebenen Kodierungen entspricht. Die Sequenz umfaßt im Anschluß an diesen zweidimensionalen Hochfrequenzimpuls einen schichtselektiven refokussierenden Hochfrequenzimpuls $RF_{i2}$, der von einem magnetischen Gradientenfeld $G_{x1}$ mit in x-Richtung verlaufenden Gradienten begleitet wird. Dadurch wird die Untersuchung auf die zur x-Richtung senkrechte Schicht beschränkt, deren Transversalmagnetisierung durch den Hochfrequenzimpuls $RF_{i2}$ refokussiert wird.

Das nach diesem Hochfrequenzimpuls $RF_{i2}$ auftretende MR-Signal, z.B. das Signal S1, wird empfangen und vom Analog-Digital-Wandler 23 in ein digitales Signal umgesetzt. Die Fouriertransformierte dieses Signals stellt das MR-Spektrum aller vier Bereiche R1...R4 dar.

Die in Fig. 4 dargestellte Sequenz wird ein zweites, drittes bzw. viertes mal wiederholt, wobei jedoch die Steuereinheit die Einhüllenden $RF_{i1}$ bzw. $RF_{r1}$ des zweiten, dritten bzw. vierten zweidimensionalen Hochfrequenzimpulses in den Generator 14 lädt, so daß sich die Signale S2, S3 bzw. S4 ergeben. Erforderlichenfalls können diese vier Sequenzen noch mehrfach wiederholt werden.

Das MR-Spektrum in den einzelnen Bereichen R1...R4 läßt sich mit Hilfe geeigneter Linearkombinationen der MR-Signale S1...S4 bzw. der daraus abgeleiteten MR-Spektren ermitteln. So errechnet sich das Signal S(R1) für den Bereich R1 nach der Formel

$$S(R1) = S1 + S2 + S3 + S4,$$

während z.B. für das Signal S(R4) für den Bereich R4 gilt:

$$S(R4) = S1 - S2 + S3 - S4.$$

Diese Operation entspricht einer Vierpunkte Hadamard-Rücktransformation.

Das Signal/Rauschverhältnis bei der geschilderten Bestimmung der spektralen Kernmagnetisierungsverteilung ist gegenüber dem Fall, in dem die MR-Spektren der einzelnen Bereiche getrennt und nacheinander ermittelt werden, um einen Faktor $\sqrt{n}$ besser; im vorliegenden Fall also um den Faktor 2.

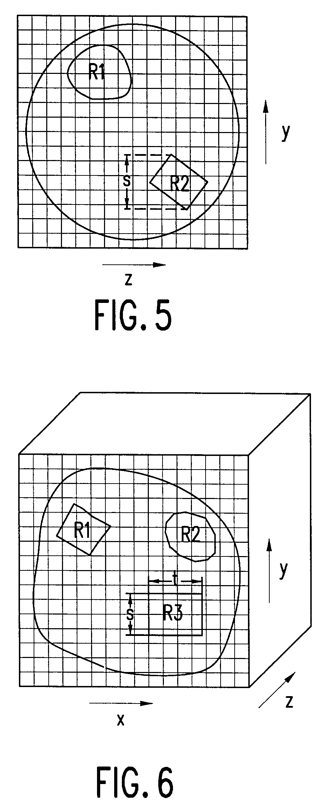

Anstatt die spektrale Verteilung der Kernmagnetisierung zu bestimmen, ist es auch möglich, die räumlich getrennten Bereiche räumlich abzubilden. Dies wird nachfolgend anhand der Figuren 5 bis 7 erläutert.

Fig. 5 zeigt ein zweidimensionales MR-Bild. Ein solches Bild kann mit Verfahren der klassischen MR-Bildgebung erstellt werden, bei dem das gesamte Bildfeld derart gemessen wird, daß es auf einer M x N-Matrix abbildbar ist. M ist dabei die Anzahl der Datenpunkte in Richtung des Lesegradienten und N die Zahl der mit verändertem Phasenkodiergradienten zu erzeugenden Sequenzen. Oft sind in einem solchen Bild aber nur ausgewählte Bereiche von Interesse, z.B. die in dem Bild mit R1 und R2 bezeichneten. Im übrigen Teil des Bildfeldes können Blutgefäße oder andere Quellen für starke Flußartefakte sein, die nicht abgebildet werden sollen. Es besteht daher der Wunsch nach Erzeugung von nur die Bereiche R1 und R2 abbildenden MR-Bildern.

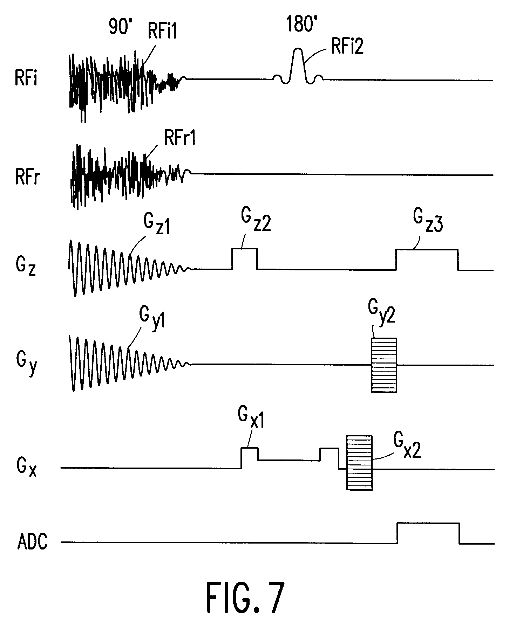

Fig. 7 zeigt eine einzelne Sequenz zur Anregung zur gleichzeitigen Anregung der Bereiche R1 und R2 in Fig. 5. Die Sequenz nach Fig. 7 entspricht weitgehend derjenigen nach Fig. 1, wobei lediglich in z-Richtung während des Auslesens des MR-Signals ein magnetisches Gradientenfeld $G_{z3}$ eingeschaltet ist, dem ein magnetisches Gradientenfeld $G_{z2}$ vorangeht, dessen zeitliches Integral halb so groß ist wie das von $G_{z3}$, und daß zwischen dem 180°-Impuls $RF_{i2}$ und dem zweidimensionalen Hochfrequenzimpuls $RF_{i1}$ ein sich zeitlich veränderndes Gradientenfeld $G_{z2}$ liegt. Außerdem wird vor dem Auslesen des MR-Signales ein in y-Richtung wirkender Phasenkodiergradient $G_{y2}$ eingeschaltet, der s mal wiederholt werden muß, wobei von Wiederholung zu Wiederholung der Phasenkodiergradient in Stufen geändert wird. Die Zahl s ergibt sich aus der in Phasenkodierung größeren Ausdehnung der beiden Regionen, dividiert durch die räumliche Auflösung dr, bzw. sie gibt an, wieviel Bildpunkte in Richtung des Phasenkodierungsgradienten der in diese Richtung größere Bereich (R2) umfaßt. Da der zweidimensionale Impuls die beiden räumlich getrennten Bereiche R1 und R2 anregt - und nur diese - wären beide Bereiche nach der Rekonstruktion in der Phasenkodierrichtung nicht mehr zu unterscheiden, und es würde zu Faltungsartefakten kommen. Um diese Faltungsartefakte zu verhindern, werden die beiden Bereiche R1 und R2 durch zwei verschiedene zweidimensionale Hochfrequenzimpulse beaufschlagt, die die Phase der Kernmagnetisierung in diesen Bereichen wie folgt codieren:

| Puls | R1 | R2 | MR-Signal |
|------|----|----|-----------|
| 1 | + | + | → S1 |
| 2 | + | - | → S2 |

Die Berechnung der Einhüllenden für diese beiden verschiedenen zweidimensionalen Hochfrequenzimpulse erfolgt, wie in Verbindung mit Fig. 4 erläutert. Die Rekonstruktion der Kernmagnetisierungsverteilung in den einzelnen Regionen erfolgt wiederum durch eine Linearkombination der MR-Signale S1, S2, und zwar gilt:

$$S(R1) = S1 + S2 \text{ und}$$

$$S(R2) = S1 - S2.$$

Dies ist äquivalent einer Zweipunkt-Hadamard-Transformation bzw. einer Zweipunkt-Fouriertransformation. Anstatt die MR-Signale in der angegebenen Weise zu kombinieren, können auch deren Fouriertransformierte oder aber auch die aus den MR-Signalen S1 bzw. S2 in Verbindung mit den Phasenkodierungen rekonstruierten Bilder in der angegebenen Weise überlagert werden. Es resultiert dann die Fouriertransformierte für die beiden Bereiche bzw. unmittelbar ein MR-Bild der beiden Bereiche.

Das beschriebene Verfahren hat gegenüber einem konventionellen MR-Abbildungsverfahren dann einen Vorteil, wenn das Produkt aus der Zahl der Bereiche n und der Zähl s kleiner ist als die Zahl N der Phasenkodierschritte, die bei einem Standard-2DFT-Verfahren erforderlich wäre, um das Gesamtbild mit der gleichen Auflösung dr zu rekonstruieren. Um diese Meßzeitvorteile voll auszuschöpfen, soll die Richtung des Lesegradienten (im Beispiel ist das die z-Richtung) und die Richtung des Phasenkodiergradienten (im Beispiel: y) so gewählt werden, daß die maximale Ausdehnung der Bereiche in Phasenkodiertichtung möglichst klein ist.

Der zuvor dargestellte Sachverhalt läßt sich auch auf einen dreidimensionalen Fall ausdehnen. Fig. 6 stellt einen solchen dreidimensionalen Fall dar, wobei die Kernmagnetisierungsverteilung in drei nicht miteinander zusammenhängenden Bereichen R1, R2 und R3 ermittelt werden soll. In diesem Fall müssen zwei Raumrichtungen (x,y) phasenkodiert werden, während der Lesegradient in der dritten, dazu senkrechten Richtung verläuft. Weiterhin sei angenommen, daß R3 sowohl in x als auch in y-Richtung die größten Abmessungen der drei Bereiche haben möge, wobei seine Länge in x-Richtung t Bildpunkte und in y-Richtung s Bildpunkte betragen möge.

Die in Verbindung mit Fig. 5 dargestellte Sequenz der Fig. 7 müßte dann so geändert werden, daß der schichtselektive Impuls $R_{i2}$ ebenso wie der Selektionsgradient $G_{x1}$ entfallen würde und stattdessen ein Phasenkodiergradient $G_{x2}$ eingeschaltet würde, der t mal wiederholt würde. Außerdem müßte das Vorzeichen von $G_{z2}$, umgekehrt werden. Gegenüber einer konventionellen Abbildung des Gesamtbereiches durch ein 3DF-Verfahren, bei dem das Gesamtbild ebenfalls in zwei Richtungen phasenkodiert würde, ergibt sich genau dann ein Meßzeitvorteil, wenn die Bedingung

$$n \cdot s \cdot t < N \cdot K$$

erfüllt wäre. Dabei ist n die Zahl der räumlich voneinander getrennten Bereiche, N und K die Zahl der Bildpunkte in x bzw. in y-Richtung für ein Standard-3DFT-Verfahren. Im allgemeinen ist diese Bedingung schon bei einfachen örtlichen Einschränkungen der Bereiche R1, R2 und R3 erfüllt, so daß sich eine drastische Verkürzung der Meßzeit ergibt.

Wenn man den Lesegradienten $G_{z3}$ und den Defokussierungsgradienten $G_{z2}$ bei der Erfassung des MR-Signals wegläßt, ergibt sich eine räumlich zweidimensional auflösende spektroskopische Bildgebung.

Bei der anhand der Figuren 5 bis 7 erläuterten Ermittlung der räumlichen Verteilung der Kernmagnetisierung in den verschiedenen Bereichen wurde von 2DFT- bzw. 3DFT-Verfahren ausgegangen, die vor jedem Erfassen des MR-Signals eine erneute Anregung der Kernmagnetisierung in den betreffenden Bereichen erfordern. Die Erfindung ist aber auch in Verbindung mit MR-Verfahren anwendbar, die - wie EPI oder dergleichen - im Anschluß an einen anregenden Hochfrequenzimpuls nacheinander mehrere MR-Signale mit alternierender Polarität des Lesegradienten auslesen. Vor jedem Auslesen wird die Phase in einer zu der Leserichtung senkrechten ersten Richtung durch einen kurzen Impuls ("blip") geändert (für eine zweidimensionale Abbildung). Bei der Fassung der Kernmagnetisierungsverteilung in einem dreidimensionalen Bereich erfolgt auf entsprechende Weise eine Phasenkodierung in einer zweiten Richtung, die zu der ersten Richtung und zu der Richtung des Lesegradienten senkrecht steht.

Auch in diesem Fall kann die Beschränkung der Anregung der Kernmagnetisierung auf die ausgewählten Bereiche dazu führen, daß die Zahl der für eine Rekonstruktion erforderlichen MR-Signale verringert wird.

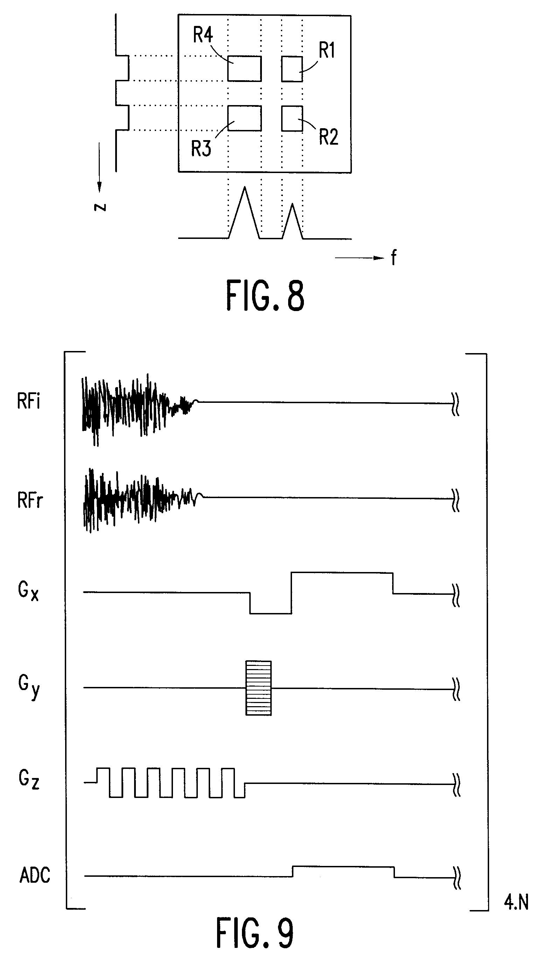

Bei der Erläuterung der Erfindung würde davon ausgegangen, daß es sich bei den nicht zusammenhängenden Bereichen um räumlich zwei- oder dreidimensionale Bereiche handelt. Die Erfindung kann jedoch auch auf den Fall einer räumlichen und einer spektralen Dimension übertragen werden. Eine solche Konstellation ergibt sich z.B. dann, wenn in zwei in z-Richtung gegeneinander versetzten Ebenen jeweils ein Fett- und ein Wasserbild ermittelt werden soll (Fett und Wasserbilder haben geringfügig voneinander abweichende Frequenzen aufgrund der chemischen Verschiebung). Dies entspricht somit der Rekonstruktion der Kernmagnetisierungsverteilung in vier Bereichen des (z,f)-Raums (z=Ortzkoordinate, f=Frequenz), wie in Fig. 8 dargestellt.

Eine für diesen Zweck geeignete Sequenz ist in Fig. 9 angegeben. Wie man Hochfrequenzimpulse erzeugt, die die Kernmagnetisierung gleichzeitig räumlich und spektral selektiv anregen, ist in Magn. Reson. Med. 15, 287-304 (1990) im einzelnen beschrieben. Für die vier Bereiche der Fig. 8 werden vier derartige Impulse benötigt, die die Kernmagnetisierung in den vier Bereichen in unterschiedlicher Weise codieren. Mit derartigen Impulsen kann in Verbindung mit den üblichen Lesegradienten ($G_x$) bzw. Phasenkodiergradienten ($G_y$) eine übliche MR-Bildgebung erfolgen.

Die in Fig. 9 dargestellte Sequenz muß 4N mal wiederholt werden, so daß sich keine Meßzeitvorteile gegenüber einem Verfahren ergeben, bei dem man nacheinander Fett- bzw. Wasserbilder in den beiden Ebenen ermittelt. Da durch die räumliche und spektral selektiven Hochfrequenzimpulse jedoch alle vier Bereiche gleichzeitig angeregt werden, ergibt sich ein um den Faktor 2 günstigeres Signal-Rausch-Verhältnis.

**Patentansprüche**

1. Verfahren zum Bestimmen der räumlichen und/oder spektralen Verteilung der Kernmagnetisierung in n getrennten Bereichen innerhalb eines Objektes mit folgenden Schritten:

    a) Vorgabe von n linear unabhängigen Kodierungen der Phase und/oder der Amplitude der Kernmagnetisierung in den n getrennten Bereichen.
    b) Erzeugen von n verschiedenen mehrdimensionalen Hochfrequenzimpulsen, die so gestaltet sind, daß die Kernmagnetisierung nur in den n Bereichen angeregt wird und zwar jeweils entsprechend einer der n Kodierungen.
    c) Erfassung der MR-Signale, die im Anschluß an die Anregung der Kernmagnetisierung in den Bereichen auftreten.
    d) Bildung von Linearkombinationen der MR-Signale oder daraus linear abgeleiteter MR-Daten zur Ermittlung der Kernmagnetisierungsverteilung in jeweils einem der Bereiche.

2. Verfahren nach Anspruch 1 zur Untersuchung räumlich getrennter Bereiche, dadurch gekennzeichnet, daß räumlich mehrdimensionale Hochfrequenzimpulse verwendet werden und daß die Schritte c) und ggf. b) mehrfach wiederholt werden, wobei nach jedem Hochfrequenzimpuls und vor der Erfassung des resultierenden MR-Signals ein erstes magnetisches Gradientenfeld mit in einer ersten Richtung verlaufendem Phasenkodiergradienten erzeugt wird, dessen zeitliches Integral vor jeder erneuten Erfassung eines MR-Signals verändert wird.

3. Verfahren nach Anspruch 2, dadurch gekennzeichnet, daß die Schritte c) und ggf. b) in mehreren Zyklen wiederholt werden, wobei von Zyklus zu Zyklus das zeitliche Integral über das erste Gradientenfeld geändert wird, daß jeder Zyklus seinerseits mehrere Wiederholungen umfaßt, wobei vor einer erneuten Erfassung des resultierenden MR-Signals ein zweites magnetisches Gradientenfeld mit in einer zweiten Richtung verlaufendem Phasenkodierung erzeugt wird, dessen zeitliches Integral von Wiederholung zu Wiederholung verändert wird.

4. Verfahren nach einem der Ansprüche 2 oder 3, dadurch gekennzeichnet, daß während der Erfassung der MR-Signale jeweils ein magnetisches Gradientenfeld wirksam ist, dessen Gradient in einer dritten, zu der Richtung des bzw. der Phasenkodiergradienten senkrechten Richtung verläuft.

5. Verfahren nach Anspruch 1 oder 3, dadurch gekennzeichnet, daß räumlich mehrdimensionale Hochfrequenzimpulse verwendet werden und daß zwecks Bestimmung der spektralen Kernmagnetisierungsverteilung in den Bereichen während der Erfassung der MR-Signale keine magnetischen Gradientenfelder wirksam sind.

6. Verfahren nach Anspruch 1, dadurch gekennzeichnet, daß mehrere räumlich getrennte Bereiche in mehreren getrennten Frequenzbereichen angeregt werden und daß die Zahl der Kodierungen bzw. der verschiedenen Hochfrequenzimpulse dem Produkt aus der Zahl der räumlich getrennten Bereiche und der Zähl der Frequenzbereiche entspricht.

7. MR-Gerät zur Durchführung des Verfahrens nach Anspruch 1 mit

    a) einer Hochfrequenzspulenanordnung zum Erzeugen von Hochfrequenzimpulsen
    b) einer Gradientenspulenanordnung zum Erzeugen zeitlich veränderlicher magnetischer Gradientenfelder
    c) einer Spulenanordnung zum Empfang von MR-Signalen
    d) einer Rekonstruktionseinheit zum Rekonstruieren der Kernmagnetisierungsverteilung aus den empfangenen MR-Signalen
    e) einer Interaktion Einheit (9) zur Definition von beliebig geformten, voneinander getrennten Bereichen ($R_1 ... R_4$)
    f) Mitteln zur Vorgabe der Phase und oder der Kodierung in n getrennten Bereichen
    g) einer Steuereinheit zum Steuern der Komponenten derart, daß folgende Schritte durchgeführt werden:
    h) Erzeugen von n verschiedenen Hochfrequenzimpulsen, die so gestaltet sind, daß die Kernmagnetisierung nur in den n Bereichen angeregt wird und zwar jeweils entsprechend einer der n Kodierungen.
    i) Erfassung der MR-Signale, die im Anschluß an die Anregung der Kernmagnetisierung in den Bereichen auftreten.
    j) Bildung von Linearkombinationen der MR-Signale oder daraus linear abgeleiteter MR-Daten zur Ermittlung der Kernmagnetisierungsverteilung in jeweils einem der Bereiche.

FIG. 1

EP 0 774 672 A1

FIG. 2

FIG. 3

FIG. 4

FIG. 5

FIG. 6

FIG. 7

FIG. 8

FIG. 9

4.N

**Europäisches Patentamt**

## EUROPÄISCHER RECHERCHENBERICHT

Nummer der Anmeldung

EP 96 20 3143

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | MAGNETIC RESONANCE IN MEDICINE, Bd. 31, 1994, Seiten 596-600, XP002026130 W. DREHER, D. LEIBFRITZ: "Double-Echo Multislice Proton Spectroscopic Imaging ..." * das ganze Dokument * --- | 1-7 | G01R33/48 |
| X | JOURNAL OF MAGNETIC RESONANCE, Bd. 80, 1988, Seiten 162-167, XP002026131 L. BOLINGER, J.S. LEIGH: "Hadamard Spectroscopic Imaging (HSI) for Multivolume Localization" * das ganze Dokument * --- | 1-7 | |
| A | JOURNAL OF MAGNETIC RESONANCE, SERIES A, Bd. 105, 1993, Seiten 78-81, XP000402842 G. GOELMAN, J.S. LEIGH: "Hadamard Spectroscopic Imaging Technique ..." * das ganze Dokument * --- | 1-7 | **RECHERCHIERTE SACHGEBIETE (Int.Cl.6)** |
| A | EP 0 361 671 A (KABUSHIKI KAISHA TOSHIBA) * Seite 2, Zeile 33 - Seite 3, Zeile 33 * * Seite 4, Zeile 46 - Seite 7, Zeile 50 * * Abbildungen 1,3-6,9-12 * ----- | 1-7 | G01R |

Der vorliegende Recherchenbericht wurde für alle Patentansprüche erstellt

| Recherchenort | Abschlußdatum der Recherche | Prüfer |
|---|---|---|
| DEN HAAG | 27.Februar 1997 | Volmer, W |

EPO FORM 1503 03.82 (P04C03)